# EUROPEAN PATENT SPECIFICATION

(11) **EP 0 167 493 B1**
(45) Date of publication and mention of the grant of the patent: **18.05.1994**
(21) Application number: 85830004.9
(22) Date of filing: 10.01.1985
(51) Int. Cl.: H01R 9/09, H01R 4/02

(54) **Edge clip**
Randklemme
Agrafe de bord

(30) Priority: 11.01.1984 US 569800
(43) Date of publication of application: 08.01.1986
(73) Proprietor: NORTH AMERICAN SPECIALITIES CORPORATION, Flushing New York 11354 (US)
(72) Inventor: Seidler, Jack, Flushing New York 11354 (US)
(74) Representative: Righetti, Giuseppe

(56) References cited:
- US-A- 3 764 955
- US-A- 4 120 558
- US-A- 4 203 648
- US-A- 4 367 910
- US-A- 4 433 892

## Description

### Field of the Invention

This invention relates generally to terminal clips or edge clips for attachment to contacts pads on a circuit-bearing chip of the type disclosed in the preamble of claim 1.

The clip is preferably of the type wherein solder is mechanically engaged with the clip in a position to be melted for bonding the clip to the contact pad. More particularly, the present invention relates to such a clip which is manufactured from a relatively wide blank of stock material which is folded upon itself to form a very narrow clip, whereby the pitch or distance between adjacent clips can be considerably reduced relative to prior art devices.

### Prior Art:

Various terminal clips are known in the prior art which have a quantity of solder associated therewith so that when the clip has been positioned on a contact pad of a circuit-bearing chip and the assembly heated, the molten solder covers the adjacent surfaces of the clip and pad to form, when cool, a soldered metallurgical joint between the clip and pad For instance, various arrangments of solder holding and/or pad contacting fingers are disclosed in Seidler US-A-4,120,558 and US-A-4,203,648 in each of which the body portions from which the fingers are formed are flat and wide enough so that each of the fingers will have adequate strength for its intended purpose.

However, an increased commercial need for miniaturization in this field has resulted in reduction of the size and spacing between the contact pads on the circuit bearing chip. Since such pads are fully supported by the material of the chip, no difficulty is encountered by the reduced size and spacing of such contact pads. The terminal clips which are attached to the pads, on the other hand, must also be reduced in size to enable reduced spacing thereof for attachment to the more closely spaced pads on the circuit bearing chip. Construction of the terminal clips in accordance with the prior art may result in the clips not having enough inherent strength to be self-supporting as they are applied to the pads, and to maintain good electrical contact with their respective pads while being soldered.

It is not economical to increase the gauge of the stock material from which the terminals are stamped since a very thin strip is electrically satisfactory. Applicant's US-A-4,367,910, dated January 11, 1983, describes one solution to this problem. In this document, the terminal clip is stamped from a relatively wide piece of stock material and then folded upon itself to achieve a narrower configuration while retaining sufficient inherent strength to be self-supporting. The terminal clips are supported from one end on a carrier strip and have free ends which are unsupported. Elongate slits are made from the free end to define parallel, separate sections of the blank which are then folded in a desired manner to provide spring fingers. In that method of manufacture, the clip is supported only from one end.

### SUMMARY OF THE INVENTION

Accordingly, it is a principal object of the present invention to provide a terminal clip or edge clip for attachment to a contact pad on a circuit-bearing chip, wherein the edge clip is made from a relatively wide blank or piece of stock material and folded upon itself to provide a narrow edge clip which has sufficient inherent strength to be self-supporting.

A further object of the invention is to provide an edge clip having a pair of spaced apart spring fingers for receiving the edge of a circuit-bearing chip therebetween, wherein the fingers have a width substantially as great as the width of the clip body and are disposed in overlying relation to the clip body to define a narrow clip.

A still further object of the invention is to provide an edge clip made from a blank or piece of stock material, in which the blank is supported from both ends on carrier strips or rails during the manufacturing process.

More particularly, the invention relates to an edge clip as disclosed in the characterizing part of claim 1.

The planar blank is formed to constitute an elongated clip body joined via lateral fold portions with stubs connected to spaced carrier rails, with a pair of parallel spring fingers extending in opposite directions away from a common connecting and fold portion integral with an edge of the body portion intermediate the ends of the body portion. The fingers and stubs are in alignment with one another and define a support axis for the blanks.

One end of the body portion may be separated from the carrier rail near the fold portion to which the fingers are connected, leaving a strip of terminal or edge clips carried by one carrier strip and having a free end with the spring fingers thereon for receiving the edge of a circuit bearing chip there-between. If desired, the other carrier rail can be separated from the body portion after the fingers have been attached to the edge of a circuit bearing chip, defining a shorting edge clip.

### BRIEF DESCRIPTION OF THE DRAWINGS

With particular reference to the drawings, several forms of the invention are illustrated in the various figures, wherein like reference characters designate like parts throughout the several views, and wherein:
Figure 1 represents a perspective view of an individual clip, the carrier rails being broken away;
Figure 2 represents an elevational view of a pair of adjacent clips carried on a single rail, the position of the (removed) second rail being indicated in broken lines;
Figure 3 represents an edge view of the clips shown in Figure 2;
Figure 4 represents a view like Figure 3, showing break-away notches to facilitate separating of the clip body from either or both carrier rails;
Figure 5 represents an elevational view of a pair of clips, as in Figure 2, showing a first modified form of clip, having solder held only in the upper fingers;
Figure 6 represents an edge view of the clips shown in Figure 5;
Figure 7 represents an elevational view of a pair of clips, as in Figures 2 and 5, showing a second modified form of clip, having a solder held only in the lower fingers;
Figure 8 represents an edge view of the clips shown in Figure 7;
Figure 9 and 10 are elevations and side edge views, respectively, of a third modification of the invention, the fingers carrying no solder; and
Figures 11 and 12 are diagrammatic edge views of two typical applications, respectively, of the edge clips according to the invention.

### DETAILED DESCRIPTION OF THE PREFERRED EMBODIMENTS

In the manufacture of the edge clip according to the invention, a strip of stock material is supplied from a reel, not shown, to a power press or stamping machine, not shown. A series of punches and dies are arranged in the power press to perform a series of successive stamping operations on the ribbon or strip of material as it passes through the machine.

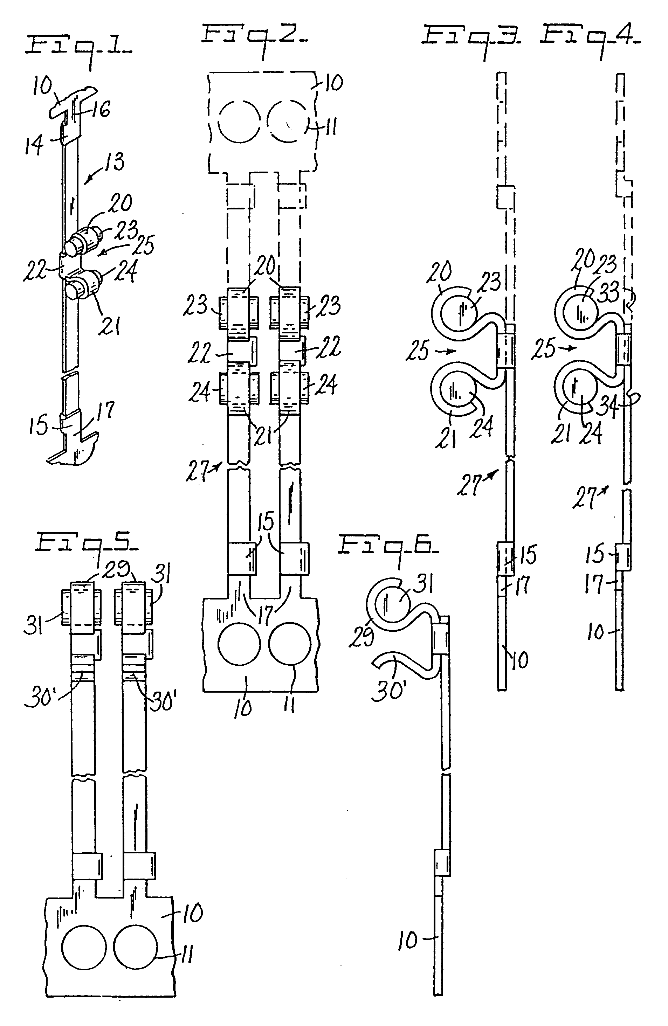

In accordance with conventional practices, carrier strips 10 are provided each having a series of pilot holes 11 formed therein for indexing the ribbon through the various stages of the power press or stamping machine. Each clip comprises an elongated clip body portion 13 having laterally projecting fold portions 14 and 15 folded to lie flat against the body portion at opposite ends thereof, respectively, and connected with stub members 16 and 17, which have a width substantially equal to that of the body and extend in opposite directions parallel to the length of the body; the stubs members are initially joined with the respective carrier strips. A finger forming strip 20 and 21, also having a width substantially equal to that of the body, projects in longitudinally opposite directions from a connecting fold portion 22, integral with an edge of the clip body 13 intermediate the ends thereof and folded to lie flat against the clip body, as shown in Figure 1. The fingers 20 and 21 are shown in Figures 1 to 5 as being bent to partially encircle (through more than 180°) masses of solder 23, 24, while projecting laterally from the face of the clip body to constitute a pair of spaced apart spring fingers defining a chip receiving gap 25.

Thus, as can be seen from the foregoing, a relatively narrow terminal or edge clip is provided, in which each of the respective portions of the blank, folded 180° in the same direction about a common axis to form the various elements of the clip, has a width substantially as wide as the widest part of the clip, thereby ensuring maximum strength for each part of the clip.

As seen in Figures 2 and 3, the upper end of the clip body and its associated carrier strip are removed, leaving a strip of terminal clips 27 carried by the lower carrier strip or rail 10 and having the spring fingers 20 and 21 on the free ends thereof for attachment to the edge of a circuit bearing chip.

The edge clips 27 shown in Figures 2 and 3 may substantially be further deformed to define a direct attach clip 27', as shown in Figure 12.

Alternatively, as shown in Figures 4 and 11, the clip body 13 may be provided with one or a pair of break-away notches 33 and 34 adjacent to the point of attachment with the spring fingers, whereby the removal of opposite ends of the body is facilitated, i.e., in order to form a shorting edge clip 27'', as illustrated in Figure 11.

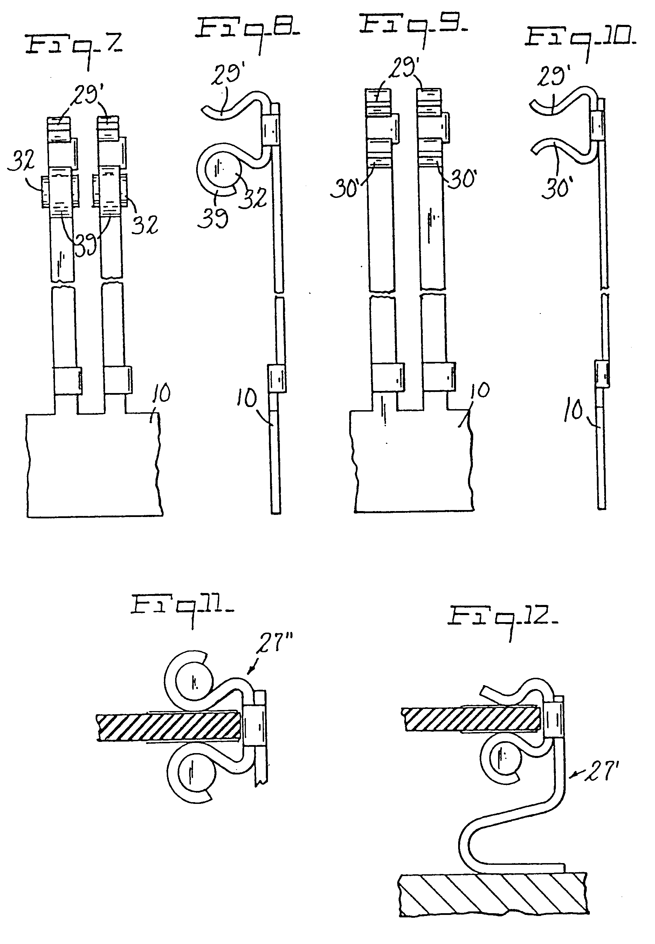

In Figures 5 and 6, a modification is shown wherein a mass of solder 31 is carried only by the top finger 29, and the bottom finger 30', is shortened and serves merely as a spring finger cooperating with the spring finger 29 in attaching the clip to the edge of a board.

Figures 7 and 8 show a similar arrangement wherein the mass of solder 32 is carried only by the bottom finger 39, while the top finger 29' is shortened and serves merely as a spring finger which cooperates with finger 39 to attach the clip to the edge of the board.

In Figures 9 and 10, neither of the fingers 29' or 30' carries any solder, and both the fingers are shortened and merely grip the edge of a board therebetween.

With the relatively narrow edge clips of the present invention, pitches as small as 0.127 cm. (.050") may be readily used, since each component or element of the clip has a width as great as the width of the clip itself, thus imparting maximum strength to the clips.

## Claims

1. An edge clip for securement to a contact pad on a circuit-bearing board, comprising:
a straight, narrow elongated clip body (13) having two ends and a pair of fingers curved in directions to provide a gap (25) for receiving an edge of a a circuit-bearing board;
a finger-forming strip (20-21) shorter than the clip body (13), and having a width substantially equal to the width of the clip body (13);
a connecting fold portion (22) joining the clip body (13) laterally to the finger forming strip (20-21)
characterized in that it comprises
a laterally projecting fold portion (14-15) adjacent each end of the clip body (13);
a stub member (16-17) extending from each laterally projecting fold portion (14-15) in opposite directions parallel to the lenght of the clip body (13), each stub member (16-17) having a width substantially equal to the width of the clip body (13); said connecting fold portion (22) connecting an intermediate portion of the clip body (13) to an intermediate portion of the finger forming strip (20-21);
the laterally projecting fold portions (14-15) and the connecting fold portion (22) being in longitudinal alignment and all being folded 180° in the same direction whereby each stub member (16-17) and the intermediate portion of the finger-forming strip (20-21) lie closely adjacent the surface of the elongated clip body (13);
the portions of finger-forming strip (20-21) beyond its intermediate portion constituting said pair of fingers (20-21) and being bent away from the plane of said intermediate portion.

2. An edge clip according to claim 1 wherein the laterally projecting fold portions (14-15) and the connecting fold portion (22) are folded about a common axis.

3. An edge clip according to claim 1 wherein at least one of said fingers (20-21) is engaged with a mass of solder (23-24).

## Patentansprüche

1. Randkralle zur Befestigung an einem Kontaktplättchen an einer gedruckten Schaltplatte, umfassend
- einen geradlinigen, schmalen, länglichen Krallenkörper (13) mit zwei Enden und einem Paar Klinken, die in Richtungen gekrümmt sind, um einen Hohlraum (25) zur Aufnahme eines Randes einer gedruckten Schaltplatte zu schaffen,
- einen die Klinken bildenden Streifen (20-21), der kürzer als der Krallenkörper (13) ist und eine Breite hat, die im wesentlichen der Breite des Krallenkörpers (13) gleich ist,
- einen Anschlußfaltteil (22), der den Krallenkörper (13) an dem die Klinken bildenden Streifen (20-21) seitlich anschließt,
dadurch gekennzeichnet, daß sie
- einen seitlich hinausragenden Faltteil (14-15), der an jedem Ende des Krallenkörpers (13) anliegt, und
- ein Endelement (16-17) umfaßt, das sich von jedem der seitlich hinausragenden Faltteilen (14-15) in entgegengesetzte Richtungen parallel der Längsrichtung des Krallenkörpers (13) erstreckt, wobei jedes Endelement (16-17) eine Breite hat, die im wesentlichen der Breite des Krallenkörpers (13) gleich ist, wobei der genannte Anschlußfaltteil (22) einen Mittelteil des Krallenkörpers (13) mit einem Mittelteil des die Klinken bildenden Streifens (20-21) verbindet,
wobei die seitlich hinausragenden Faltteile (14-15) und der Anschlußfaltteil (22) in Längsrichtung fluchten und alle um 180°C in die selbe Richtung gekrümmt sind, so daß jedes Endelement (16-17) und der Mittelteil des die Klinken bildenden Streifens (20-21) an der Oberfläche des länglichen Krallenkörpers (13) eng anliegen,
wobei die Teile des die Klinken bildenden Streifens (20-21) getrennt von dessen Mittelteil das genannte Paar Klinken bilden und in Entfernung von der Ebene des genannten Mittelteils gekrümmt sind.

2. Randkralle nach Anspruch 1, wobei die seitlich hinausragenden Faltteile (14-15) und der Anschlußfaltteil (22) um eine gemeine Achse gekrümmt sind.

3. Randkralle nach Anspruch 1, wobei wenigstens eine der genannten Klinken (20-21) an eine Lotmasse (23-24) angreift.

## Revendications

1. Agrafe de bord pour la fixation à un patin de contact sur une plaque de circuit imprimé, comprenant:
- un corps (13) d'agrafe droit, étroit et allongé, ayant deux extrémités et une paire de doigts courbés suivant des directions permettant de former une cavité (25) destinée à recevoir un bord d'une plaque de circuit imprimé:
- une bande (20-21) formant les doigts, plus courte que le corps d'agrafe (13) et ayant une largeur sensiblement égale à la largeur du corps d'agrafe (13);
- une portion de pliage de liaison (22) joignant le corps (13) de l'agrafe latéralement à la bande (20-21) formant le doigt,
caractérisée en ce qu'elle comporte:
- une portion de pliage faisant saillie latéralement (14-15) adjacente à chaque extrémité du corps (13) de l'agrafe;
- un élément terminal (16-17) s'étendant depuis chaque portion de pliage faisant saillie latéralement (14-15) selon des directions opposées, parallèlement à la longeur du corps (13) de l'agrafe, chaque élément terminal (16-17) ayant une largeur sensiblement égale à la largeur du corps (13) de l'agrafe; ladite portion de pliage de liaison (22) reliant une portion intermédiare du corps d'agrafe (13) à une portion intermédaire de la bande formant le doigt (20-21);
- les portions de pliage (14-15) faisant saillie latéralement et la portion de pliage (22) de liaison étant en alignement longitudinal et étant toutes repliées de 180° dans la même direction, de sorte que chaque élément terminal (16-17) et la portion intermédiaire de la bande (20-21) formant le doigt sont disposés étroitement adjacents à la surface du corps d'agrage (13) allongé;
- les portions de la bande (20-21) formant le doigt au-delà de sa portion intermédiaire réalisant ladite paire de doigts (20-21) et étant repliée a l'écart du plan de ladite portion intermédiare.

2. Agrafe de bord selon la revendication 1, caractérisée en ce que les portions de pliage (14-15) faisant saillie latéralement et la portion de pliage (22) de liaison sont repliées autour d'un axe commun.

3. Agrafe de bord selon la revendication 1, caractérisée en ce qu'au moins un desdits doigts (20-21) est engagé à une masse de soudure.
